# DEMANDE DE BREVET EUROPEEN

(11) **EP 0 950 501 A1**
(43) Date de publication de la demande: **20.10.1999**
(21) Numéro de dépôt: 98201171.0
(22) Date de dépôt: 16.04.1998
(51) Int. Cl.: B29C 65/12

(54) **Procédé de fabrication d'un cordon de soudure pour revêtements de sols et cordon de soudure obtenu**

(71) Demandeur: Sommer Revêtements France S.A., 92748 Nanterre Cedex (FR)
(72) Inventeur: Mallen,Jean, 38150 Chanas (FR)
(74) Mandataire: Van Malderen, Michel

(57) **Abrégé**

On procède à une extrusion au départ d'un mélange de granules classiques pour une composition extrudable d'une première couleur comportant une proportion déterminée de granules d'une deuxième couleur, ces granules de deuxième couleur présentant des caractéristiques de comportement thermique differentiel par rapport aux granules de la première couleur, de manière qu'aux températures d'extrusion, elles ne subissent pas une fusion complète mais restent au moins partiellement à l'état solide.

Application à des cordons de soudure pour revêtements de sols thermoplastiques (tels que le PVC) ou pour des revêtements de sols thermodurcissables (tels que le linoleum).

## Description

### Objet de l'invention

La présente invention concerne un procédé de production d'un cordon de soudure destiné à des revêtements de sols et s'étend au cordon de soudure obtenu de cette manière.

### Arrière-plan technologique à la base de l'invention

Il est classique de recourir à un cordon de soudure lors de la pose de lés de produits de revêtement de sol en PVC, linoléum et autres matières, qu'elles soient thermoplastiques ou thermodurcissables.

Le principe est de poser bord à bord les lisières des lés ou, dans certains cas, de les superposer légèrement et de trancher ensuite les lisières. En principe, quelle que soit la technique utilisée, les lés obtenus sont posés de manière pratiquement jointive. On fraise ensuite les bords des lés jointifs pour créer une rainure, généralement en forme de V. Dans cette rainure est posé ensuite un cordon de soudure thermofusible, généralement du PVC si le revêtement de sol est dans cette matière ou un produit du type hot melt tel qu'un copolymère éthylène-acétate de vinyle pour des produits thermodurcissables du type linoléum.

Généralement, on réalise une rainure de quelques millimètres et on choisit un cordon de soudure dont le diamètre est égal à la largeur de la rainure formée. Ce cordon remplit donc la rainure en débordant de celle-ci.

Après refroidissement du cordon, la partie débordante de celui-ci est arasée à l'aide d'un outil spécifique.

Différentes couleurs de cordons sont généralement proposées. Dans certains cas, on cherche à créer un contraste entre la couleur du joint et la couleur générale du revêtement de sol. Dans la plupart des cas, on cherche cependant à obtenir une harmonie de couleurs.

Un assez grand nombre de revêtements de sol présentent cependant l'aspect d'une masse de fond d'une première couleur avec des inclusions formées de particules, de granules ou d'incrustations d'une couleur différente afin d'obtenir des dessins "granités" (produits qualifiés de "in-laids").

A priori, on pourrait envisager d'utiliser un joint de la couleur dominante du revêtement de sol du type in-laid. Cette solution ne donne cependant pas parfaitement satisfaction.

Il a été proposé d'utiliser, selon le brevet US-5 635 266 A, un cordon de soudure destiné à des revêtements de sols du type vinylique (en vue d'obtenir une surface homogène paraissant monolithique). Le cordon de soudure est réalisé spécifiquement pour reproduire l'apparence du matériau de revêtement de sol.

Pour obtenir une structure ressemblant à une produit pourvu d'incrustations, une feuille de particules multicolores présentant une formulation similaire mais différente de celle du revêtement de sol est préparée et la feuille est coupée en bandes thermoformées dans un moule, et ensuite soit les parties thermoformées sont collées bout à bout, soit elles subissent un formage complémentaire jusqu'à la longueur désirée.

Une technique similaire est décrite dans le document GB-2 283 937 A.

Dans le document EP-0 775 563 A2, on décrit un cordon de soudure constitué d'une première couche de matière thermoplastique, d'une seconde couche thermoplastique transparente avec une couche imprimée disposée entre chacune d'elles. Les produits laminés sont mis en forme par moulage.

Des cordons de cette nature sont cependant particulièrement onéreux compte tenu de la technique de fabrication.

### Buts de l'invention

L'invention vise à proposer un procédé moins onéreux et plus simple pour la réalisation de cordons de soudure du type décrit, constitués d'une matrice comportant des inclusions du type des granules, des incrustations ou des particules utilisées dans des produits du type in-laids.

### Eléments caractéristiques de l'invention

Classiquement, les cordons de soudure unis, c'est-à-dire sans inclusions, sont réalisés par extrusion dans une filière qui leur confère la forme et la dimension souhaitées.

Cependant, l'extrusion a tendance à réaliser un mélange intime des constituants. Il y a donc une perte d'identité des particules individuelles.

Selon l'invention, on procède à une extrusion au départ d'un mélange de granules classiques pour une composition extrudable d'une première couleur comportant une proportion déterminée de granules d'une deuxième couleur, ces granules présentant des caractéristiques de comportement thermique differentiel par rapport aux granules de la première couleur, de manière qu'aux températures d'extrusion, elles ne subissent pas une fusion complète mais restent au moins partiellement à l'état solide.

Le choix des matériaux est déterminé d'une part par la nature des lés qu'ils sont destinés à solidariser. Dans le cas de matières purement thermoplastiques telles que le PVC, il est possible d'utiliser en principe des matériaux du même type.

Pour d'autres matériaux, en particulier les matériaux thermodurcissables, on a recours à des produits du type "hot melt" tels que les copolymères éthylène-acétate de vinyle. En principe, les deux constituants mis en oeuvre par extrusion pour la formation du lé sont de natures chimiques proches afin d'assurer une bonne compatibilité de ces matières.

Pour obtenir l'effet souhaité de comportement thermique différentiel, on peut jouer par exemple sur la teneur en adjuvants connus pour modifier les caractéristiques de fluidité. Dans le cas d'utilisation de produits thermoplastiques, des adjuvants notamment du type plastifiants permettent de modifier les caractéristiques.

Le spécialiste des matières plastiques connaît de nombreuses possibilités d'agir à ce niveau, et quelques essais d'extrusion lui permettront aisément, en fonction des matières mises en oeuvre, d'ajuster la teneur des adjuvants pour obtenir l'effet souhaité.

La technique préconisée par l'invention n'exclut pas la possibilité de procéder à une extrusion simultanée de granules d'une troisième couleur, dont le comportement thermique est encore différent du comportement des granules de la première et de la deuxième couleur ou qui est identique au comportement thermique de l'un de ces types de granules.

La technique de l'invention sera décrite plus en détails à l'aide de l'exemple qui suit.

### Exemple

L'exemple se rapporte à la production d'un cordon de soudure multicolore à base de PVC sur base de deux couleurs.

On procède au mélange d'une première composition comme suit (parties en poids)
- PVC: 100
- Plastifiant (phtalate): 40 à 70
- Charge minérale: 0 à 10
- Stabilisants: 2 à 8
- Cire: 0 à 2
- Pigments: q.s.

Sur base de la composition typique précitée, on produit une deuxième composition comportant des pigments différents et en utilisant une quantité d'adjuvants, en particulier de plastifiant, de manière à obtenir des caractéristiques de fluidité différentes des caractéristiques de fluidité de la première composition.

Chacun des lots de la première composition et de la seconde composition sont obtenus sous forme de granulés d'une épaisseur de 2 à 6 mm.

Sans mélanger entre eux les lots de composition différente, ceux-ci subissent un broyage et un tamisage de façon à obtenir des granulés de petites dimensions, unicolores et présentant des caractéristiques de fluidité différentes.

On réalise un tamisage à l'aide de tamis avec des trous de par exemple 4 mm. Bien entendu, par la même technique il est possible de réaliser un troisième lot qui se distingue des deux premiers, au moins par le choix des pigments et généralement également par le fait que l'on choisit des indices de fluidité différents de ceux du premier et deuxième lots.

En fonction des types de cordon que l'on souhaite réaliser, des granules sont prélevées en proportion déterminée des différents lots individuels et sont mélangées en proportion choisie. Pour la réalisation du cordon, le mélange multicolore est alimenté dans une extrudeuse dont la température de travail est choisie en fonction des indices de fluidité, de façon à ne provoquer tout au plus qu'une fusion partielle du ou des granules présentant l'indice de fluidité le plus élevé.

La température dans l'extrudeuse est croissante, par exemple de l'ordre de 42°C dans une zone d'entrée, ensuite 49°C, 60°C et 95°C dans trois zones suivantes et 160°C à la tête dont est extrait un jonc multicolore servant à produire le cordon muticolore.

Après refroidissement le cordon obtenu, soit tel quel, soit sous forme découpée, est enroulé en bobine.

Bien que l'on ait décrit et illustré par un exemple des formes d'exécution de l'invention, il doit être bien entendu que de nombreuses variantes opératoires et opérations complémentaires restent possibles dans le cadre des revendications qui suivent.

## Revendications

1. Procédé de fabrication d'un cordon de soudure multicolore pour revêtements de sol, caractérisé en ce qu' on procède à une extrusion au départ d'un mélange de granules classiques pour une composition extrudable d'une première couleur comportant une proportion déterminée de granules d'une deuxième couleur, ces granules d'une deuxième couleur présentant des caractéristiques de comportement thermique differentiel par rapport aux granules de la première couleur, de manière qu'aux températures d'extrusion, elles ne subissent pas une fusion complète mais restent au moins partiellement à l'état solide.

2. Procédé selon la revendication 1, caractérisé en ce qu'on met en oeuvre des matières purement thermoplastiques telles que le PVC afin de produire un cordon destiné à souder des revêtements de sol thermoplastiques.

3. Procédé selon la revendication 1, caractérisé en ce qu'on met en oeuvre des matériaux du type "hot melt" tels que les copolymères éthylène-acétate de vinyle afin de produire un cordon destiné à des matériaux thermodurcissables du type linoleum.

4. Procédé selon l'une quelconque des revendications 1 à 3, caractérisé en ce qu'on adapte la teneur en adjuvants des granules pour obtenir des caractéristiques de fluidité différentes en fonction des couleurs.

5. Procédé selon l'une quelconque des revendications 1 à 4, caractérisé en ce qu'on procède à une extrusion simultanée de granules d'au moins d'une troisième extrusion simultanée de granules d'au moins d'une troisième couleur, dont le comportement thermique est encore différent du comportement des granules de la première et de la deuxième couleur ou qui est identique au comportement thermique de l'un de ces types de granules.
